# EUROPÄISCHE PATENTSCHRIFT

(11) **EP 1 543 384 B1**
(45) Veröffentlichungstag und Bekanntmachung des Hinweises auf die Patenterteilung: **18.01.2012**
(21) Anmeldenummer: 03750374.5
(22) Anmeldetag: 23.09.2003
(51) Int. Cl.: G03F 1/00, H01B 1/12

(54) **ZUSAMMENSETZUNG, DIE EINE ELEKTRISCH LEITFÄHIGE LACKSCHICHT BILDET UND EIN VERFAHREN ZUR STRUKTURIERUNG EINES FOTORESISTS UNTER VERWENDUNG DER LACKSCHICHT**
COMPOSITION WHICH FORMS AN ELECTRICALLY-CONDUCTING PROTECTIVE COAT AND A METHOD FOR STRUCTURING A PHOTORESIST USING THE PROTECTIVE LAYER
COMPOSITION FORMANT UNE COUCHE DE VERNIS ÉLECTROCONDUCTRICE ET PROCÉDÉ DE STRUCTURATION D'UN PHOTORESIST A L'AIDE DE CETTE COUCHE DE VERNIS

(30) Priorität: 23.09.2002 DE 10244197
(43) Veröffentlichungstag der Anmeldung: 22.06.2005
(73) Patentinhaber: Qimonda AG, 81739 München (DE)
(72) Erfinder: ABARGUES, Rafael, 91056 Erlangen (DE); ELIAN, Klaus, 91088 Bubenreuth (DE)
(74) Vertreter: Epping - Hermann - Fischer
(86) Internationale Anmeldenummer: PCT/DE2003/003161
(87) Internationale Veröffentlichungsnummer: WO 2004/029716

(56) Entgegenhaltungen:
- EP-A- 0 540 448
- US-A- 5 137 799
- US-A- 5 188 767
- US-A- 5 721 091
- US-A- 5 721 091
- US-A1- 2002 032 271
- US-A1- 2002 037 994
- US-A1- 2002 037 994

## Beschreibung

In der Halbleitertechnologie werden immer häufiger auf einem Substrat befindliche Fotoresists mittels elektrisch geladener Teilchen, beispielsweise Elektronen, strukturiert. Die Strukturierung mittels Elektronenstrahllithographie ermöglicht dabei höher aufgelöste Strukturen als optische Lithographietechniken. Vor allen Dingen bei der Herstellung von Lithographiemasken, die in der Regel aus einem Quarzglassubstrat mit einer aufgebrachten strukturierten Metallschicht, beispielsweise Chrom bestehen, werden die zu erzeugenden Strukturen in der Metallschicht und dem Quarzglassubstrat immer kleiner. Die Lithographiemasken weisen dabei Strukturen auf, die mittels Belichtung, z.B. mit UV-Strahlung auf einen Photoresist übertragen werden, der sich auf einen zu strukturierenden Halbleitersubstrat befindet. Die feinen Strukturen der Lithographiemasken sind darauf zurückzuführen, daß in die Masken häufig sogenannte OPC-Strukturen (Optical Proximity Correction) integriert werden, die wesentlich kleiner als die eigentlich abzubildenden Strukturen sind. Die OPC-Strukturen umfassen z.B. sehr kleine Strukturen, die dazu dienen, die Modifizierung der Maskenstruktur durch das Licht zu kompensieren.

Weiterhin ist die Herstellung von sogenannten Phasenschiebermasken besonders anspruchsvoll, da hier auf die Maske zusätzliche Schichten aufgebracht werden müssen, beziehungsweise das Maskensubstrat nach der Strukturierung der Metallschicht definiert abgetragen wird, um mittels Interferenz die gewünschten Phasensprünge bei der Belichtung eines Photoresists auf einem Halbleitersubstrat zu erreichen.

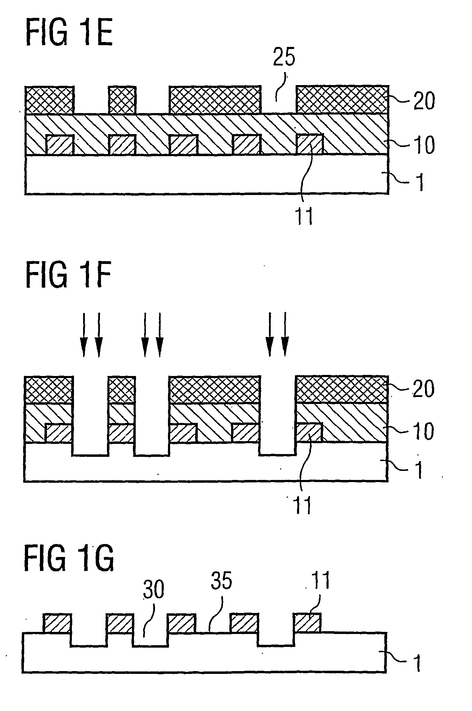

Die Herstellung der Phasenschiebermasken erfordert in der Regel zwei separate lithographische Strukturierungsschritte von Photoresists. Im ersten Schritt wird eine, auf dem Maskensubstrat, dem Quarzglassubstrat befindliche Metallschicht, beispielsweise Chrom strukturiert. Dazu wird auf die Chromschicht eine Fotoresistschicht aufgebracht und diese mittels eines Elektronenstrahls strukturiert und anschließend entwikkelt. Da auf dem Maskensubstrat eine durchgehende Metallschicht vorhanden ist, kann die entstehende negative elektrische Aufladung der Maske noch problemlos abgeleitet werden. Die im Fotoresist vorhandene Struktur kann dann beispielsweise mittels eines Sauerstoff/Chlorplasmas auf die Chromschicht übertragen werden. Bei der Herstellung von Phasenschiebermasken muß anschließend darüber hinaus häufig das Quarzglassubstrat ebenfalls strukturiert werden (siehe z.B. Fig. 1G). Dazu wird ebenfalls ein Fotoresist auf die Maske mit der vorstrukturierten Chromschicht aufgebracht und anschließend mittels eines Elektronenstrahls strukturiert. Aufgrund der bereits vorstrukturierten, nicht mehr auf dem gesamten Quarzglassubstrat vorhandenen Chromschicht ist hier keine ganzflächige Ableitung der Ladung mehr möglich, so daß sich das Quarzglassubstrat während des Schreibvorganges negativ auflädt. Diese negative Aufladung beeinflußt den Elektronenstrahl, der sowohl zum Schreiben als auch zur Justierkontrolle nötig ist. Diese Beeinflussung führt zu einer unerwünschten Ablenkung und Aufweitung des Elektronenstrahls, was besonders während des Justierens störend ist, aber auch zu unerwünschten Verzerrungen und Fehlern beim Strukturieren des Fotoresists führt. Aus diesem Grund wird im zweiten Lithographieschritt der Fotoresist bislang häufig optisch strukturiert, was allerdings den Nachteil hat, daß nicht so hohe Auflösungen wie beim Strukturieren mittels eines Elektronenstrahls erzielt werden können.

In der Patentschrift US 5 721 091 A wird ein Verfahren zur Strukturierung von Fotoresists beschrieben, bei dem auf ein bestimmtes Substrat eine elektrisch leitfähige Schicht aufgebracht wird. Die elektrisch leitfähige Schicht umfasst sulfoniertes Polyanilin, Lösungsmittel, Amine und/oder quaternäre Ammoniumsalze.

Ziel der vorliegenden Erfindung ist es daher, eine Zusammensetzung anzugeben, die eine elektrisch leitfähige Lackschicht bildet und die beim Strukturieren von Fotoresists mittels elektrisch geladener Partikel dazu verwendet werden kann, die entstehende Ladung abzuleiten.

Diese Aufgabe wird mit einer Zusammensetzung nach Anspruch 1 gelöst. Vorteilhafte Ausgestaltungen der Zusammensetzung sowie ein Verfahren zur Strukturierung eines Fotoresists unter Verwendung der Lackschicht sind Gegenstand der Unteransprüche.

Eine erfindungsgemäße Zusammensetzung, die eine elektrisch leitfähige Lackschicht bildet, umfaßt die folgenden Komponenten:

Als Komponente A) ein zu einem Basispolymer vernetzbares Harz, welches Phenol-Formaldehyd-Harze umfasst, als Komponente B) eine zu einer elektrisch leitfähigen Substanz vernetzbare organische Verbindung, als Komponente C) ein oxidativ oder reduktiv wirkendes Vernetzungsmittel und als Komponente D) zumindest ein Lösungsmittel.

Durch Vernetzung der erfindungsgemäßen Zusammensetzung kann eine elektrisch leitfähige Lackschicht gebildet werden, die besonders stabil und inert gegenüber gängigen wässrigen Entwicklersystemen von Fotoresists ist. Gleichzeitig weist die elektrisch leitfähige Lackschicht eine ausreichend hohe Leitfähigkeit im Bereich von z.B. 10⁻⁴ bis 10⁻¹ S/cm² auf, die eine sehr gute Ableitung der elektrischen Ladungen ermöglicht. Darüber hinaus läßt sich die elektrisch leitfähige Lackschicht besonders gut mittels reaktiver Plasmen, beispielsweise eines Sauerstoffplasmas ätzen.

Ein weiterer Vorteil der durch die erfindungsgemäße Zusammensetzung gebildeten Lackschicht besteht darin, daß diese mit einer Partikelgröße < 0,2 µm erzeugt werden kann. Deshalb lassen sich in dieser Lackschicht Strukturen mit hoher Auflösung verwirklichen. Die Partikelgröße einer Schicht limitiert in der Regel die Auflösung der Strukturen, die in die Schicht eingebracht werden können. Viele elektrisch leitfähige Polymere, z.B. Polyacetylene weisen sehr große Partikelgrößen > 0,5 µm auf, so daß sie nicht mit hoher Auflösung strukturiert werden können.

Komponente A) ist vorteilhaft thermisch vernetzbar, was beispielsweise bei sogenannten selbstvernetzenden Harzen der Fall ist. Als selbstvernetzende Harze kommen Phenol-Formaldehydharze, beispielsweise Novolak- oder Kresol in Betracht. Diese haben den Vorteil, daß sie auch Bestandteil von herkömmlichen chemisch verstärkten Fotolacken (CA-Resists) sind, so daß eine besonders gute chemische Verträglichkeit der elektrisch leitfähigen Lackschicht mit eventuell auf dieser Lackschicht aufzubringenden Fotoresists resultiert.

Komponente B) ist günstigerweise oxidativ vernetzbar, wobei dann Komponente C) ein Oxidationsmittel ist. Komponente B) kann ausgewählt sein aus niedermolekularen, mindestens 6 konjugierte π-Elektronen aufweisenden organischen Verbindungen und elektrisch leitfähigen Polymeren. Komponente B) kann aus den Verbindungsklassen Pyrrole, Furane, Thiophene, Aniline, Naphtaline, Anthracene und Vinylidene ausgewählt sein, wobei die genannten Grundkörper jeweils beliebig substituiert sein können. Unter Vinylidenen sind aliphatische, organische Verbindungen mit konjugierten Doppelbindungen zu verstehen.

Besonders vorteilhaft ist Komponente B) aus Pyrrol, Hexylthiophen, Furan, Thiophen, Bithiophen, EDOT (3,4-Ethylendioxythiophen) und Terthiophen ausgewählt. Diese als Komponente B) genannten Verbindungen stellen sogenannte intrinsisch leitfähige Verbindungen dar, die als Monomere beziehungsweise Oligomere nicht leitend sind und mittels oxidativer Polyermisation (Vernetzung) in elektrisch leitfähige Verbindungen überführt werden können. Verwendet werden können auch kurzkettige Polymere, die mittels oxidativer Polymerisation anschließend in längerkettige Polymere überführt werden können.

Als oxidativ wirksames Vernetzungsmittel lassen sich besonders gut Eisen-III-chlorid und Kupferperchlorat Cu(ClO₄)₂ einsetzen. Komponente C) kann aber auch aus anderen, auch organischen Oxidationsmitteln ausgewählt sein.

Unter Vernetzung im Sinne der Erfindung werden dabei Vernetzungen von Makromolekülen, z.B. einzelnen Harz-Molekülen miteinander zu dreidimensionalen Netzwerken und auch Polymerisationen also Überführungen niedermolekularer Verbindungen in hochmolekulare Verbindungen, verstanden.

Prinzipiell ist es auch möglich, intrinsisch leitfähige Verbindungen zu verwenden, die mittels reduktiver Vernetzung in elektrisch leitfähige organische Verbindungen überführt werden können. In diesen Fällen ist Komponente C) vorteilhafterweise ein Reduktionsmittel.

Komponente D) ist günstigerweise aus den Lösungsmitteln Methoxypropylacetat, Ethyllactat, Ethylacetat, Cyclohexanon, Cyclopentanon, Gammabutyrolacton, Hexanol, Tetrahydrofuran, Methanol und Acetonitril ausgewählt. Diese Lösungsmittel, sowie deren Mischungen sind besonders gut geeignet, das zu einem Basispolymer vernetzbare Harz, die zu einer elektrisch leitfähigen Substanz vernetzbare organische Verbindung und das Vernetzungsmittel zu lösen und damit hochkonzentrierte und für eine Beschichtung geeignet viskose Zusammensetzungen zu schaffen.

Bei einer Vernetzung einer erfindungsgemäßen Zusammensetzung werden dabei nicht nur kovalente Bindungen zwischen einzelnen Molekülen des Harzes oder einzelnen Molekülen der zu einer elektrisch leitfähigen Substanz vernetzbaren organischen Verbindung geknüpft, sondern auch kovalente Bindungen zwischen dem Basispolymer und der elektrisch leitfähigen organischen Verbindung ausgebildet. Dies hat den Vorteil, daß eine besonders gut gegenüber chemischen Lösungsmitteln inerte, durch ein verzweigtes Molekülgerüst aufgebaute, elektrisch leitfähige Lackschicht bei der Vernetzung gebildet wird. Wenn Komponente A) beispielsweise Novolak ist, so können die aromatischen OH-Gruppen mit weiteren OH-Gruppen von Novolak-Oligomeren reagieren, wobei auch Reaktionen dieser OH-Gruppe mit den aromatischen Ringen der Komponente B), z.B. Thiophen, möglich sind.

Vorteilhafterweise umfaßt eine erfindungsgemäße Zusammensetzung als Komponente A1) einen Quervernetzer. Diese Verbindung kann während der Vernetzung der Zusammensetzung mit einzelnen Molekülen des Harzes zusätzlich quervernetzen und somit weitere kovalente Bindungen ausbilden. Möglich ist auch eine Reaktion des Quervernetzers mit der zu einer elektrisch leitfähigen Substanz vernetzbaren organischen Verbindung.

Als Quervernetzer lassen sich besonders gut organische Verbindungen mit mehr als zwei vernetzbaren funktionellen Gruppen, z.B. OH-Gruppen oder Aminogruppen verwenden. Beispielsweise finden Alkylolmelamin-Verbindungen, z.B. Methylolmelamin-Verbindungen wie Hexamethylolmelamin Verwendung. Möglich ist auch die Verwendung von Tetraalkylacetalen, z.B. dem Tetramethylacetal des Terephthal-Aldehyds.

Komponente A) ist vorteilhafterweise in einem Anteil von 2 bis 20 Gew-% an der gesamten Zusammensetzung vorhanden. Komponente B) ist in einem Anteil von 0,5 bis 10 Gew-% an der gesamten Zusammensetzung und Komponente C) in einem Anteil von 0,5 bis 10 Gew-% an der gesamten Zusammensetzung vorhanden. Komponente D), das Lösungsmittel, kann zwischen 40 bis 95 Gew-% der gesamten Zusammensetzung ausmachen.

Eine besonders vorteilhafte erfindungsgemäße Zusammensetzung weist als Komponente A) Novolak, als Komponente A1) Methylolmelamin, als Komponente B) Terthiophen, als Komponente C) Kupferperchlorat und als Komponente D) Methoxypropylacetat auf.

Eine andere Variante einer erfindungsgemäßen Zusammensetzung weist als Komponente A) etwa 4,9 Gew.% Novolak, als Komponente B) etwa 1 Gew.% Terthiophen, als Komponente C) etwa 49,5 Gew.% einer etwa 4-prozentigen Eisenchloridlösung in Tetrahydrofuran und als Komponente D) etwa 55,4 Gew% Methoxypropylacetat auf.

Gegenstand der Erfindung ist weiterhin ein Verfahren zur Strukturierung einer Fotoresistschicht unter Verwendung der aus der erfindungsgemäßen Zusammensetzung gebildeten elektrisch leitfähigen Lackschicht. In einem Verfahrensschritt a) wird auf ein Substrat eine erfindungsgemäße Zusammensetzung aufgebracht, danach in einem Verfahrensschritt b) die Zusammensetzung vernetzt, wobei die elektrisch leitfähige Lackschicht erzeugt wird und anschließend in einem Verfahrensschritt c) eine strukturierbare Fotoresistschicht auf der Lackschicht erzeugt. Danach können in einem Verfahrensschritt d) in der Fotoresistschicht mittels elektrisch geladener Partikel Strukturen unter Ableitung von elektrischer Ladung über die Lackschicht erzeugt werden.

Die elektrisch geladenen Partikel können dabei Elektronen, Protonen oder beispielsweise Alphateilchen sein. Der Vorteil des erfindungsgemäßen Verfahrens besteht darin, daß die elektrisch leitfähige Lackschicht besonders gut die elektrische Ladung ableitet, so daß mittels der elektrisch geladenen Partikel mit besonders guter Auflösung die auf der elektrisch leitfähigen Lackschicht befindliche Fotoresistschicht strukturiert werden kann. Während der Erzeugung der Strukturen wird das Substrat z.B. über einen sog. x-y-Tisch in Maskenschreibern noch geerdet. Da die Entwicklung von herkömmlichen Fotoresistschichten in der Regel mittels wässriger, beispielsweise alkalischer Entwickler erfolgt, besteht ein weiterer Vorteil des erfindungsgemäßen Verfahrens darin, daß die aus der erfindungsgemäßen Zusammensetzung gebildete elektrisch leitfähige Lackschicht nicht in wässrigen Entwicklern löslich ist, so daß die Fotoresiststrukturen nicht unterspült werden können, was eventuell bei sehr feinen Strukturen sogar zu einem kompletten Wegspülen führen kann. Weiterhin sind die erfindungsgemäßen Lackschichten besonders gut verträglich mit herkömmlichen Fotoresists.

In einer weiteren Ausgestaltung des erfindungsgemäßen Verfahrens können in einem nach dem Verfahrensschritt d) in einem Verfahrensschritt e) stattfindenden Schritt die Strukturen in der Fotoresistschicht durch die Lackschicht hindurch auf das Substrat übertragen werden. Dies kann beispielsweise mittels eines Sauerstoffplasmas und/oder eines fluorhaltigen Plasmas geschehen. Als Substrat läßt sich beispielsweise eine Fotomaske, zum Beispiel aus Quarzglas verwenden. Weiterhin ist es möglich, als Substrat eine Fotomaske zu verwenden, auf der zumindest teilweise eine strukturierte Metallschicht angeordnet ist. Wie bereits oben erwähnt, kann in diesem Fall besonders vorteilhaft die erfindungsgemäße elektrisch leitfähige Lackschicht trotz der Unterbrechung der strukturierten Metallschicht eine besonders gute Ladungsableitung ermöglichen.

Zur Vernetzung im Verfahrensschritt b) wird die Zusammensetzung vorteilhafterweise erhitzt. Dies ermöglicht es im Zusammenspiel mit dem Vernetzungsmittel besonders einfach, gleichzeitig die Komponenten A) und B) untereinander zu verknüpfen.

Im Verfahrensschritt d) kann die Fotoresistschicht mittels eines Elektronenstrahls strukturiert werden.

In einem weiteren Verfahrensschritt f) nach dem Verfahrensschritt e) können sowohl der Fotoresist als auch die elektrisch leitfähige Lackschicht entfernt werden, wobei das strukturierte Substrat freigelegt wird.

Im folgenden soll die Erfindung anhand von Figuren und Ausführungsbeispielen noch näher erläutert werden.

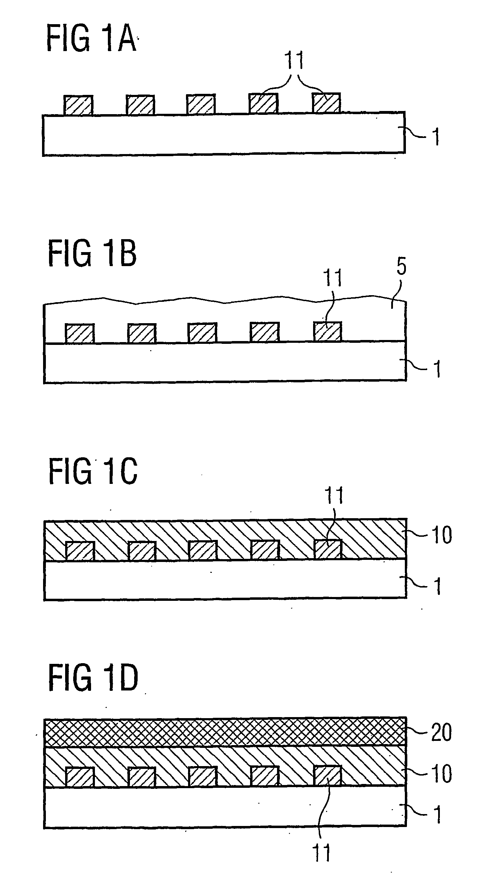

Die Figuren 1A bis 1G zeigen eine Variante eines erfindungsgemäßen Verfahrens.

In Figur 1A ist ein Substrat 1 mit darauf aufgebrachter strukturierter Metallschicht 11 im Querschnitt zu sehen. Im Falle eines Verfahrens zur Herstellung von Fotomasken besteht das Substrat 1 beispielsweise aus Quarzglas und die strukturierte Metallschicht beispielsweise aus Chrom.

Figur 1B zeigt den ersten Verfahrensschritt a) des erfindungsgemäßen Verfahrens im Querschnitt. Dabei wird die erfindungsgemäße Zusammensetzung 5 auf das Substrat aufgebracht. Dies kann beispielsweise mittels Spincoating erfolgen.

Figur 1C zeigt einen Querschnitt der Anordnung auf dem Substrat nach dem erfindungsgemäßen Verfahrensschritt b). Durch Spincoating ließ sich die Zusammensetzung 5 als planare Schicht auf dem Substrat erzeugen und z.B. mittels thermischer Aufheizung vernetzen, so daß die elektrisch leitfähige Lackschicht 10 auf dem Substrat 1 und der strukturierten Metallschicht 11 erzeugt wurde.

Figur 1D zeigt die Anordnung auf dem Substrat nach dem Verfahrensschritt c) des erfindungsgemäßen Verfahrens. Dabei ist mittels herkömmlicher Methoden eine Fotoresistschicht 20 auf der elektrisch leitfähigen Lackschicht 10 erzeugt worden. Dabei kann es sich beispielsweise um einen mittels Elektronenstrahlen strukturierbaren Fotoresist handeln.

Figur 1E zeigt die Anordnung nach dem Verfahrensschritt d), der Strukturierung der Fotoresistschicht 20 mittels elektrisch geladener Partikel, beispielsweise Elektronen. Dabei wurden Strukturen 25 in der Fotoresistschicht erzeugt, die keine Verzerrungen aufweisen, da die elektrische Ladung des Substrats 1 besonders gut über die elektrisch leitfähige Lackschicht 10 abgeleitet werden konnte.

Figur 1F zeigt den zusätzlichen Verfahrensschritt e) des erfindungsgemäßen Verfahrens, bei dem beispielsweise mittels eines trocknen Plasmaätzverfahrens die in der Fotoresistschicht vorhandenen Strukturen 25 durch die Lackschicht 10 hindurch auf das Substrat 1 übertragen werden.

Figur 1G zeigt im Querschnitt die Anordnung nach Entfernung der Fotoresistschicht und der elektrisch leitfähigen Lackschicht (Verfahrensschritt f). Im Falle einer Fotomaske, bei der das Substrat 1 beispielsweise Quarzglas ist und die strukturierte Metallschicht 11 beispielsweise Chrom ist, wurde eine Phasenschiebermaske hergestellt. Dabei sind diejenigen Bereiche, auf denen das Chrom angeordnet ist, nicht durchlässig für das in der lithographischen Strukturierung eines Halbleiters benutzte Licht. Bereiche 35, in denen das Quarzglassubstrat nicht geätzt wurde, sind durchlässig für das Licht, wobei keine Phasenverschiebung stattfindet. Bereiche 30 des Quarzglassubstrats, die geätzt wurden, sind ebenfalls durchlässig für das Licht, verursachen aber eine Phasenverschiebung.

### Ausführungsbeispiel 1:

Eine erfindungsgemäße Zusammensetzung wird dadurch hergestellt, daß als Komponente A) 49,5 g der Novolaklösung BLC-001 der Firma Tokyo Ohka mit 1 g Terthiophen der Firma Aldrich (Komponente B) versetzt werden. Dazu werden 49,5 g einer 4-prozentigen Lösung aus wasserfreiem Eisen-III-chlorid in Tetrahydrofuran gegeben (Komponenten C und D). Die erhaltene Zusammensetzung wird für 30 Minuten auf einem Schüttelgerät innig vermischt.

Die erfindungsgemäße Zusammensetzung wird auf einem 4" Siliziumtestwafer durch Spincoaten (4000 rpm 20 Sekunden) aufgebracht. Anschließend wird durch Vernetzung die elektrisch leitfähige Lackschicht gebildet. Dazu wird die Zusammensetzung bei 160° C für 120 Sekunden aufgeheizt. Dabei verdampft ein Großteil des Lösungsmittels und es resultiert ein trockener, elektrisch leitender, dunkelgrauer, transparenter Lackfilm mit einer Schichtdicke von 0,5 µm auf dem Siliziumtestwafer.

Anschließend wird die elektrisch leitfähige Lackschicht mit einem herkömmlichen elektronstrahlstrukturierbaren Fotoresist zum Beispiel CAP 209 der Firma Tokyo Ohka, beschichtet. Der strukturierbare Fotoresist wird anschließend mittels eines Elektronenstrahlmaskenschreibers zum Beispiel aus ETEC MEBES Serie strukturiert.

Anschließend werden in einem Heizschritt zum Beispiel bei etwa 130°C für etwa 90 Sekunden (Post Exposure Bake) die latent vorhandenen Strukturen in der Fototresistschicht fixiert. Die Fotoresistschicht wird anschließend mit einer wässrigen alkalischen Entwicklerlösung zum Beispiel ca. 2,38 % Tetramethylammoniumhydroxid in Wasser für ca. 60 Sekunden entwickelt. Dabei wird der belichtete Bereich des Fotoresists entfernt. Anschließend können die im Fotoresist vorhandenen Strukturen mittels Plasmaätzens zum Beispiel mit einem Sauerstoffplasma in die elektrisch leitfähige Lackschicht übertragen werden.

### Ausführungsbeispiel 2:

Das Verfahren wird analog zu Ausführungsbeispiel 1 durchgeführt, wobei als erfindungsgemäße Zusammensetzung 49,5 g Novolaklösung BLC-001 von Tokyo Ohka mit 1 g Terthiophen versetzt und dann 49,5 g einer 4-prozentigen Lösung von Kupferperchlorat-Hexahydrat in Tetrahydrofuran hinzugegeben werden.

### Ausführungsbeispiel 3:

Das Verfahren wird analog zu den Ausführungsbeispielen 1 und 2 durchgeführt, wobei als erfindungsgemäße Zusammensetzung 49,5 g einer Kresol-Novolaklösung von Clariant mit 1 g Terthiophen versetzt werden. Dazu werden 49,5 g einer 4-prozentigen Lösung aus Kupferperchlorat-Hexahydrat in Methoxypropylacetat gegeben und die erhaltene Zusammensetzung für 30 Minuten auf einem Schüttelgerät innig vermischt.

Die Erfindung beschränkt sich nicht auf die hier dargestellten Ausführungsbeispiele. Variationen sind vor allem bei den Komponenten B) und C) möglich.

## Patentansprüche

1. Zusammensetzung, eine elektrisch leitfähige Lackschicht bildend, die folgende Komponenten umfaßt:
A) ein zu einem Basispolymer vernetzbares Harz, welches Phenol-Formaldehyd-Harze umfasst,
B) eine zu einer elektrisch leitfähigen Substanz vernetzbare organische Verbindung,
C) ein oxidativ oder reduktiv wirkendes Vernetzungsmittel,
D) zumindest ein Lösungmittel,
- wobei die Komponente A und die Komponente B über kovalente Bindungen vernetzbar sind.

2. Zusammensetzung nach einem der vorhergehenden Ansprüche,
- die zusätzlich als Komponente A1) einen Quervernetzer umfaßt.

3. Zusammensetzung nach einem der vorhergehenden Ansprüche,
- bei der Komponente A) thermisch vernetzbar ist.

4. Zusammensetzung nach einem der vorhergehenden Ansprüche,
- bei der Komponente B) oxidativ vernetzbar ist,
- bei der Komponente C) ein Oxidationsmittel ist.

5. Zusammensetzung nach einem der vorhergehenden Ansprüche,
- bei der Komponente A) ausgewählt ist aus folgenden organischen Verbindungen:
- Novolak, Kresol.

6. Zusammensetzung nach einem der vorhergehenden Ansprüche,
- bei der Komponente B) ausgewählt ist aus:
- niedermolekularen, mindestens 6 konjugierte π-Elektronen aufweisenden organischen Verbindungen und elektrisch leitfähigen Polymeren.

7. Zusammensetzung nach einem der vorhergehenden Ansprüche,
- bei der Komponente B) aus folgenden Verbindungsklassen ausgewählt ist:
- Pyrrole, Furane, Thiophene, Aniline, Naphtaline, Anthracene und Vinylidene, wobei die genannten Grundkörper jeweils substituiert sein können.

8. Zusammensetzung nach einem der vorhergehenden Ansprüche,
- bei der Komponente B) aus folgenden Verbindungen ausgewählt ist:
- Pyrrol, Hexylthiophen, Furan, Thiophen, Bithiophen, EDOT-3,4-Ethylendioxythiophenund Terthiophen.

9. Zusammensetzung nach einem der vorhergehenden Ansprüche,
- bei der Komponente C) aus folgenden Oxidationsmitteln ausgewählt ist:
FeCl₃ und Cu(ClO₄)₂.

10. Zusammensetzung nach einem der vorhergehenden Ansprüche,
- bei der Komponente D) aus folgenden Lösungsmitteln ausgewählt ist:
- Methoxypropylacetat, Ethyllactat, Ethylacetat, Cyclohexanon, Cyclopentanon, γ-Butyrolacton, Hexanol, Tetrahydrofuran, Methanol und Acetonitril.

11. Zusammensetzung nach einem der Ansprüche 2 bis 10,
- bei der Komponente A1) aus folgenden Verbindungen ausgewählt ist:
- Alkylolmelamine und Tetraalkylacetale.

12. Zusammensetzung nach einem der vorhergehenden Ansprüche,
- bei der Komponente A) in einem Anteil von 2 - 20 Gew% an der gesamten Zusammensetzung vorhanden ist.

13. Zusammensetzung nach einem der vorhergehenden Ansprüche,
- bei der Komponente B) in einem Anteil von 0,5- 10 Gew% an der gesamten Zusammensetzung vorhanden ist.

14. Zusammensetzung nach einem der vorhergehenden Ansprüche,
- bei der Komponente C) in einem Anteil von 0,5 - 10 Gew% an der gesamten Zusammensetzung vorhanden ist.

15. Zusammensetzung nach einem der vorhergehenden Ansprüche,
- bei der Komponente D) in einem Anteil von 40 - 95 Gew% an der gesamten Zusammensetzung vorhanden ist.

16. Zusammensetzung nach einem der vorhergehenden Ansprüche,
- bei der Komponente A) Kresol und Novolak,
- bei der Komponente B) Terthiophen,
- bei der Komponente C) Cu(ClO₄)₂ und
- bei der Komponente D) Methoxypropylacetat ist.

17. Zusammensetzung nach einem der Ansprüche 2 bis 16 mit
- etwa 4,9 Gew% Novolak-Polymer als Komponente A),
- etwa 2, 5 Gew% Methylolmelamin als Komponente A1)
- etwa 1 Gew% Terthiophen als Komponente B),
- etwa 3,7 Gew% Cu(ClO₄)₂ als Komponente C) und
- etwa 88 Gew% Methoxypropylacetat als Komponente D).

18. Verfahren zur Strukturierung einer Fotoresistschicht (20) mit den Verfahrensschritten,
a) auf das Substrat (1) wird eine Zusammensetzung (5) nach einen der vorhergehenden Ansprüche aufgebracht,
b) die Zusammensetzung (5) wird vernetzt, wobei die elektrisch leitfähige Lackschicht (10) erzeugt wird,
c) eine mittels elektrisch geladener Partikel strukturierbare Fotoresistschicht (20) wird auf der Lackschicht (10) erzeugt,
d) danach werden in der Fotoresistschicht (20) mittels elektrisch geladener Partikel Strukturen (25) unter Ableitung von elektrischer Ladung über die Lackschicht (10) erzeugt.

19. Verfahren nach dem vorhergehenden Anspruch,
- bei dem nach dem Verfahrensschritt d) in einem Verfahrensschritt e) die Strukturen in der Fotoresistschicht (20) durch die Lackschicht (10) hindurch auf das Substrat (1) übertragen werden.

20. Verfahren nach einem der Ansprüche 18 oder 19,
- bei dem als Substrat (1) eine Photomaske verwendet wird.

21. Verfahren nach einem der Ansprüche 18 bis 20,
- bei dem als Substrat (1) eine Photomaske verwendet wird, auf der zumindest teilweise eine strukturierte Metallschicht (11) angeordnet ist.

22. Verfahren nach einem der Ansprüche 18 bis 21,
- bei dem im Verfahrenschritt b) die Zusammensetzung (5) erhitzt wird.

23. Verfahren nach einem der Ansprüche 18 bis 22,
- bei dem im Verfahrensschritt d) die Fotoresistschicht mittels eines Elektronenstrahls strukturiert wird.

24. Verfahren nach einem der Ansprüche 19 bis 23,
- bei dem im Verfahrensschritt e) ein Sauerstoffplasma und ein fluorhaltiges Plasma bzw. Mischungen davon verwendet werden.

25. Verfahren nach einem der Ansprüche 19 bis 24,
- bei dem in einem an den Verfahrenschritt e) anschließenden Verfahrensschritt f) die strukturierte Fotoresistschicht und die elektrisch leitfähige Lackschicht entfernt werden.

## Claims

1. A composition forming an electrically conductive coat of lacquer and comprising the following components:
A) a resin which can be cured to form a basic polymer and comprises phenol formaldehyde resins,
B) an organic compound which can be cured to form an electrically conductive substance,
C) an oxidatively or reductively acting curing agent,
D) at least one solvent,
- with component A) and component B) being curable via covalent bonds.

2. The composition according to any of the preceding claims,
- additionally comprising a cross-linking agent as a component A1).

3. The composition according to any of the preceding claims,
- in which component A) is thermally curable.

4. The composition according to any of the preceding claims,
- in which component B) is oxidatively curable,
- in which component C) is an oxidizing agent.

5. The composition according to any of the preceding claims,
- in which component A) is selected from following organic compounds:
- novolak, cresol.

6. The composition according to any of the preceding claims,
- in which component B) is selected from:
- low-molecular organic compounds comprising at least six conjugated n-electrons and electrically conductive polymers.

7. The composition according to any of the preceding claims,
- in which component B) is selected from the following classes of compounds:
- pyrroles, furanes, thiophenes, anilines, naphthalenes, anthracenes and vinylidenes, with the option of the cited parent substances being substituted each.

8. The composition according to any of the preceding claims,
- in which component B) is selected from the following compounds:
- pyrrole, hexylthiophene, furan, thiophene, bithiophene, EDOT-3,4-ethylenedioxythiophene and terthiophene.

9. The composition according to any of the preceding claims,
- in which component C) is selected from the following oxidizing agents:
- FeCl₃ and Cu(ClO₄)₂.

10. The composition according to any of the preceding claims,
- in which component D) is selected from the following solvents:
- methoxypropylacetate, ethyl lactate, ethyl acetate, cyclohexanone, cyclopentanone, γ-butyrolactone, hexanol, tetrahydrofuran, methanol and acetonitrile.

11. The composition according to any of the claims 2 to 10,
- in which component A1) is selected from the following compounds:
- alkylolmelamine and tetraalkylacetale.

12. The composition according to any of the preceding claims,
- in which component A) is present in a proportion of 2 to 20 % by weight of the total composition.

13. The composition according to any of the preceding claims,
- in which component B) is present in a proportion of 0.5 to 10 % by weight of the total composition.

14. The composition according to any of the preceding claims,
- in which component C) is present in a proportion of 0.5 to 10 % by weight of the total composition.

15. The composition according to any of the preceding claims,
- in which component D) is present in a proportion of 40 to 95 % by weight of the total composition.

16. The composition according to any of the preceding claims,
- in which component A) is cresol and novolak,
- in which component B) is terthiophene,
- in which component C) is Cu(ClO₄)₂ and
- in which component D) is methoxypropylacetate.

17. The composition according to any of the claims 2 to 16, comprising
- approximately 4.9% by weight of novolak polymer as component A),
- approximately 2.5% by weight of methylolmelamine as component A1),
- approximately 1% by weight of terthiophene as component B),
- approximately 3.7% by weight of Cu(ClO₄)₂ as component C) and
- approximately 88% by weight of methoxypropylacetate as component D).

18. A method of structuring a photoresist layer (20) comprising the process steps:
a) a composition (5) according to any of the preceding claims is applied to a substrate (1),
b) the composition (5) is cured, the electrically conductive coat of lacquer (10) being produced in this process,
c) a photoresist layer (20) which can be structured by means of electrically charged particles is produced on the coat of lacquer (10),
d) thereafter, structures (25) are produced in the photoresist layer (20) by means of electrically charged particles while dissipating any electrical charge via the coat of lacquer (10).

19. The method according to the preceding claim,
- in which, after process step d) and in a process step e), the structures in the photoresist layer (20) are transferred through the coat of lacquer (10) to the substrate (1).

20. The method according to any of the claims 18 or 19,
- in which a photo mask is used as the substrate (1).

21. The method according to any of the claims 18 to 20,
- in which a photo mask is used as the substrate (1), a structured metal layer (11) being arranged at least in parts on said photo mask.

22. The method according to any of the claims 18 to 21,
- in which the composition (5) is heated in process step b).

23. The method according to any of the claims 18 to 22,
- in which the photoresist layer is structured by means of an electron beam in process step d).

24. The method according to any of the claims 19 to 23,
- in which an oxygen plasma and a plasma containing fluorine or mixtures therefrom are used in process step e).

25. The method according to any of the claims 19 to 24,
- in which the structured photoresist layer and the electrically conductive coat of lacquer are removed in a process step f) following process step e).

## Revendications

1. Composition formant une couche de vernis électroconductrice, comprenant les composantes suivantes :
A) une résine réticulable en un polymère de base, comprenant des résines de phénol-formaldéhyde,
B) une liaison organique réticulable en une substance électroconductrice,
C) un réticulant à action oxydante ou réductrice,
D) au moins un solvant,
- la composante A et la composante B étant réticulables via des liens covalents.

2. Composition selon l'une des revendications précédentes,
- qui comprend en outre comme composante A1) un réticulant transversal.

3. Composition selon l'une des revendications précédentes,
- où la composante A) est réticulable thermiquement.

4. Composition selon l'une des revendications précédentes,
- où la composante B) est réticulable par oxydation,
- où la composante C) est un agent d'oxydation.

5. Composition selon l'une des revendications précédentes,
- où la composante A) est choisie parmi les liaisons organiques suivantes :
- novolaque, crésol.

6. Composition selon l'une des revendications précédentes,
- où la composante B) est choisie parmi :
- des liaisons organiques et des polymères électroconducteurs de faible poids moléculaire comprenant au moins 6 électrons π conjugués.

7. Composition selon l'une des revendications précédentes,
- où la composante B) est choisie parmi les classes de liaisons suivantes :
- pyrroles, furanes, thiophènes, anilines, naphtalines, anthracènes et vinylidènes, les corps de base cités pouvant être chacun substitués.

8. Composition selon l'une des revendications précédentes,
- où la composante B) est choisie parmi les liaisons suivantes :
- pyrrole, hexylthiophène, furane, thiophène, biothiophène, EDOT-3,4-éthylènedioxythiophène et terthiophène.

9. Composition selon l'une des revendications précédentes,
- où la composante C) est choisie parmi les agents d'oxydation suivants :
FeCl₃ et Cu(ClO₄)₂.

10. Composition selon l'une des revendications précédentes,
- où la composante D) est choisie parmi les solvants suivants :
- méthoxypropylacétate, éthyllactate, éthylacétate, cyclohexanon, cyclopentanon, γ-butyrolacton, hexanol, tétrahydrofurane, méthanol et acétonitrile.

11. Composition selon l'une des revendications 2 à 10,
- où la composante A1) est choisie parmi les liaisons suivantes :
- alkylolmélamine et tétraalkylacétale.

12. Composition selon l'une des revendications précédentes,
- où la composante A) est présente dans une proportion de 2 à 20 % en poids de la composition totale.

13. Composition selon l'une des revendications précédentes,
- où la composante B) est présente dans une proportion de 0,5 à 10 % en poids de la composition totale.

14. Composition selon l'une des revendications précédentes,
- où la composante C) est présente dans une proportion de 0,5 à 10 % en poids de la composition totale.

15. Composition selon l'une des revendications précédentes,
- où la composante D) est présente dans une proportion de 40 à 95 % en poids de la composition totale.

16. Composition selon l'une des revendications précédentes,
- où la composante A) est du crésol et du novolaque,
- où la composante B) est du terthiophène,
- où la composante C) est du Cu(ClO₄)₂ et
- où la composante D) est du méthoxypropylacétate.

17. Composition selon l'une des revendications 2 à 16, comprenant
- environ 4,9 % en poids de polymère de novolaque comme composante A),
- environ 2,5 % en poids de méthylolmélamine comme composante A1),
- environ 1 % en poids de terthiophène comme composante B),
- environ 3,7 % en poids de Cu(ClO₄)₂ comme composante C) et
- environ 88 % en poids de méthoxypropylacétate comme composant D).

18. Procédé de structuration d'une couche photorésistante (20) moyennant les étapes de procédé suivantes :
a) une composition (5) selon l'une des revendications précédentes est appliquée sur le substrat (1),
b) la composition (5) est réticulée, la couche de vernis électroconductrice (10) étant produite,
c) une couche photorésistante (20) structurable au moyen de particules chargées électriquement est produite sur la couche de vernis (10),
d) après cela, des structures (25) sont produites dans la couche photorésistante (20) au moyen de particules chargées électriquement moyennant la dérivation de charge électrique via la couche de vernis (10).

19. Procédé selon la revendication précédente,
- où, après l'étape de procédé (d), à une étape de procédé e), les structures dans la couche photorésistante (20) sont transmises au substrat (1) à travers la couche de vernis (10).

20. Procédé selon l'une des revendications 18 ou 19,
- où un masque photographique est employé comme substrat (1).

21. Procédé selon l'une des revendications 18 à 20,
- où un masque photographique sur lequel est disposée au moins en partie une couche métallique structurée (11), est employé comme substrat (1).

22. Procédé selon l'une des revendications 18 à 21,
- où, à l'étape de procédé b), la composition (5) est chauffée.

23. Procédé selon l'une des revendications 18 à 22,
- où, à l'étape de procédé d), la couche photorésistante est structurée au moyen d'un faisceau d'électrons.

24. Procédé selon l'une des revendications 19 à 23,
- où, à l'étape de procédé e), un plasma d'oxygène et un plasma contenant du fluor ou des mélanges de ceux-ci sont employés.

25. Procédé selon l'une des revendications 19 à 24,
- où, à une étape de procédé f) consécutive à l'étape de procédé e), la couche photorésistante structurée et la couche de vernis électroconductrice sont enlevées.
